# EUROPEAN PATENT APPLICATION

(11) **EP 4 790 166 A1**
(43) Date of publication of application: **12.08.2026**
(21) Application number: 25156887.9
(22) Date of filing: 10.02.2025
(51) Int. Cl.: C23C 14/04, G03F 1/48, G03F 7/16, G03F 7/20, G03F 7/00

(54) **METHOD FOR COATING A COMPONENT OF A LITHOGRAPHIC APPARATUS**

(71) Applicant: ASML Netherlands B.V., 5500 AH Veldhoven (NL)
(72) Inventor: NIKIPELOV, Andrey, 5500 AH Veldhoven (NL); VAN DE KERKHOF, Marcus, Adrianus, 5500 AH Veldhoven (NL); SCHLEGEL, Andreas, 5500 AH Veldhoven (NL); VAN DER WOORD, Ties, Wouter, 5500 AH Veldhoven (NL); ARLEMARK, Erik, Johan, 5500 AH Veldhoven (NL)
(74) Representative: ASML Netherlands B.V.

(57) **Abstract**

A method for applying a conductive coating to a component of a lithographic apparatus, comprising: providing a carrier member in the lithographic apparatus, wherein a precursor material is disposed on the carrier member facing the component, heating the carrier member to form a vapor of the precursor material, condensing the precursor vapor onto the component to form the conductive coating.

## Description

### FIELD

The present invention relates to a method of coating components of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV radiation may contribute to the generation of active species that cause release of contaminant particles from surfaces within the lithographic apparatus. For example, the EUV radiation may interact with matter present in the lithographic apparatus (e.g. small amounts of gas) to form a plasma. The plasma may contain active species such as high-energy electrons, as well as ions and free radicals of the gas. These active species may interact with surfaces within the lithographic apparatus to release contaminant particles. For example, regions of the lithographic apparatus may contain low-pressure hydrogen gas, and the EUV beam may interact with the hydrogen to form active species such as high energy electrons, hydrogen ions (e.g. H⁺, H₂⁺, H₃⁺) and hydrogen free radicals (e.g. H*). These active species generated from hydrogen gas may interact with surfaces within the lithographic apparatus to release contaminant particles from the surfaces.

Contaminant particles may interfere with application of the desired pattern to the substrate. For example, the contaminant particles may be transported to and be incident upon sensitive optical surfaces, such as the patterning device (also known as a mask or a reticle). As another example, contaminant particles may damage components of the lithographic apparatus, thereby increasing the frequency of maintenance activity and reducing the throughput of the lithographic apparatus.

US 2024/0118603 A1 discloses a method and apparatus for reducing ruthenium oxide. US 2024/0004283 A1 discloses a membrane for use in EUR lithography. US 2020/0096880 A1 discloses that provision of a conductive coating on the surfaces within the lithographic apparatus may reduce or prevent the release of contaminant particles when an active species is incident on the surface.

Many existing lithographic apparatuses contain components which do not have a conductive coating. Replacing these existing components may lead to significant apparatus downtime, which may be undesirable. Also, a component's conductive coating may degrade over time leading to an increase in contaminants release.

It may be desirable to provide a method of coating components of a lithographic apparatus which prevents or ameliorates one or more of the problems identified above.

### SUMMARY

According to a first aspect of the present invention, there is provided a method for applying a conductive coating to a component of a lithographic apparatus, comprising: providing a carrier member in the lithographic apparatus, wherein a precursor material is disposed on the carrier member, heating the carrier member to form a vapor of the precursor material, condensing the precursor vapor onto the component to form the conductive coating.

According to a second aspect of the present invention, there is provided a reticle mini environment component comprising a conductive coating produced by the method of the first aspect of the present invention.

According to a third aspect of the present invention, there is provided a carrier member for applying a conductive coating to components of a lithographic apparatus, the carrier member comprising a carrier plate or a carrier membrane having a melting point of more than 600 K and comprising a precursor material disposed thereon.

According to a fourth aspect of the present invention, there is provided a lithographic apparatus configured to perform the method of the first aspect of the present invention wherein the apparatus is configured to control the pressure and flow of gas to the components of the lithographic apparatus to guide the precursor vapor to predetermined areas of the reticle mini environment.

### BRIEF DESCRIPTION OF THE DRAWINGS

Embodiments of the invention will now be described, by way of example only, with reference to the accompanying schematic drawings, in which:
- Figure 1 depicts a schematic diagram of a lithographic system comprising a lithographic apparatus and a radiation source;
- Figure 2 depicts a schematic diagram of a patterning device environment comprising a patterning device and components in accordance with an embodiment of the invention;
- Figure 3A depicts a schematic diagram of a particle on a dielectric substrate surface;
- Figure 3B depicts a schematic diagram of the particle being released form the dielectric substrate surface due to charging of the particle and the substrate by high energy electrons
- Figure 4A depicts a schematic of a part of a reticle mini environment showing the presence of a dielectric native oxide on the outer surface of a masking blade;
- Figure 4B depicts a schematic of the part of a reticle mini environment shown in Figure 4A after ageing, illustrating the how the masking blade outer surface composition may change over time;
- Figure 5A depicts a plan view of a carrier member, the plan view taken along line I-I' in Figure 5B;
- Figure 5B depicts a schematic diagram of a patterning device environment according to an embodiment of the invention;
- Figure 6A depicts a plan view of a carrier member, the plan view taken along line II-II' in Figure 6B;
- Figure 6B depicts a schematic diagram of a patterning device environment according to an embodiment of the invention;
- Figure 7A depicts a plan view of a carrier member, the plan view taken along line III-III' in Figure 7B;
- Figure 7B depicts a schematic diagram of a patterning device environment according to an embodiment of the invention;
- Figure 8 depicts a schematic diagram of various configurations of a carrier member according to an embodiment of the invention;
- Figure 9A depicts a schematic diagram of a patterning device environment at an initial stage of the method for applying a conductive coating according to an embodiment of the invention; and
- Figure 9B depicts a schematic diagram of the patterning device environment shown in Figure 9A after a conductive coating has been applied via a method according to an embodiment of the invention.

In the figures, like-parts are indicated with like-references.

### DETAILED DESCRIPTION

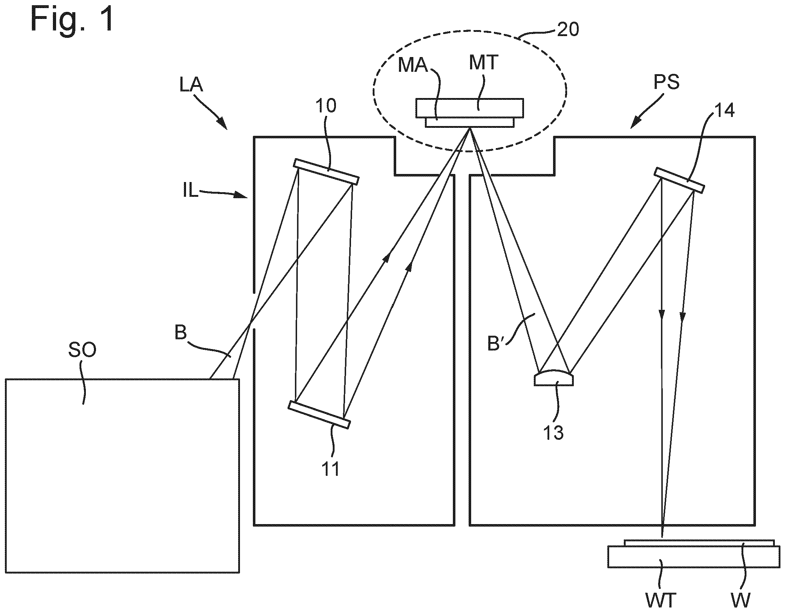

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a reticle MA), a projection system PS and a substrate table WT configured to support a substrate W.

The illumination system IL is configured to condition the EUV radiation beam B before the EUV radiation beam B is incident upon the reticle MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the reticle MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the reticle MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

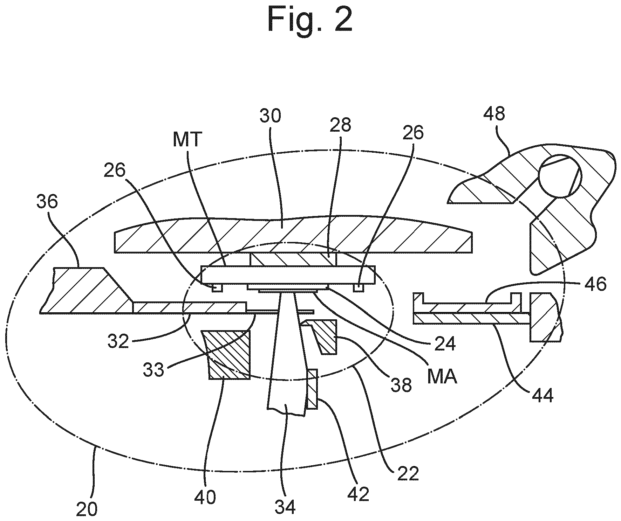

Figure 2 shows a portion of a lithographic apparatus, such as that shown in Figure 1, which may be considered to be a patterning device environment 20. The patterning device environment 20 may include the reticle MA and a plurality of components as will be described. Within the patterning device environment 20, there may be a reticle mini environment (RME) 22. The RME 22 may be defined as a region within approximately 20-50 cm of the reticle. Several of the components may be located within the RME 22.

Within the RME 22 of the patterning device environment 20 there is located a patterning device support (a support structure or a chuck) MT which is used to support the patterning device (mask) MA. A clamp 24 is used to hold the reticle MA on the patterning device support MT. Fiducial markers or fiducials 26 are located on the patterning device support MT. The fiducials 26 are used as reference points, i.e. fixed points to which other objects can be related or against which objects can be measured. Encoders are located with the fiducials 26.

Any one or more of the reticle MA, the patterning device support MT, the clamp 24, the fiducials 26 and/or the encoders may be a dielectric or at least have portions that are dielectric, e.g. one or more dielectric surfaces, or be mostly dielectric with some metallization. These components may be made from e.g. low expansion ceramics/glasses or another suitable dielectric material. These components are shown as empty boxes, i.e. not hatched parts in Figure 2.

The reticle MA may be moved by actuators, i.e. patterning device actuators. Located within the RME 22, is a short stroke patterning device actuator 28. The short stroke actuator 28 may be located in a vacuum (i.e. a relative vacuum or low-pressure environment). Located within the patterning device environment 20 there is another patterning device actuator, i.e. a long stroke actuator 30. The long stroke actuator may be provided in an environment separated from RME 22 or connected with RME 22. In the case of connected environments, measures may be implemented to prevent particles generated and displaced by operating the actuator (for example from a cable/pipe slab) from contributing to defectivity of the reticle MA.

A patterning device masking apparatus 32 is provided in the RME 22 in order to mask (or block) a radiation beam 34 (e.g. EUV beam) from being incident on the reticle MA. The patterning device masking apparatus 32 may comprise a masking blade 33 which may move across the radiation beam 34 to mask the reticle MA (i.e. stop the radiation beam 34). A patterning device masking apparatus motion/control module 36 is located in the patterning device environment 20 in order to control the movement of the patterning device masking apparatus 32.

Also located in the RME 22, is a radiation beam uniformity adjustment apparatus 38 which may be used to make sure the radiation beam 34 has the desired uniformity. Other components located at least partially in the RME 22, or wholly in the patterning device environment 20 include an illuminator top sleeve flow supply 40 (ITS flow supply 40) and a G-mirror (grazing incidence mirror) 42. The illuminator top sleeve is an environment near G-mirror 42 and may also include faceted pupil mirror device 11 (not shown in Figure 2).

A patterning device exchange apparatus 44 is included in the patterning device environment 20. The patterning device exchange apparatus 44 may be used for transferring the reticle MA to and from the patterning device support MT as required. A pod 46 located on the patterning device exchange apparatus 44 may be used to support and shield the reticle MA during transport.

Also located at least partially in the patterning device environment 20 is a gas refreshing system 48 which may be configured to maintain an atmosphere in the patterning device environment, such as an atmosphere of low-pressure hydrogen gas. The gas refreshing system 48 may be disposed within the reticle mini environment, and the gas refreshing system 48 may comprise a gas exhaust system (e.g. a pump), and a clean gas supply system. The constituent parts of the gas refreshing system 48 are omitted from Figure 2 for simplicity. The gas refreshing system 48 may be used to flush the reticle mini environment 22 or patterning device environment 20 with gas during flushing. The gas refreshing system 48 may be configured to provide a refresh of H₂ gas during a lithographic process (such as an EUV exposure). The clean gas supply system may be integrated in or near one of the masking blades 33 of the masking apparatus 32. The gas exhaust system may be a turbo-molecular pump, which may be configured to it evacuate gases, such as hydrogen (H₂) and/or extra (extreme) clean dry air (XCDA) and/or dry nitrogen (N₂). Figure 2 shows the gas refreshing system 48 as being disposed outside the RME 22, but the gas refreshing system 48 may be disposed inside the RME 22. For example, at least one of the gas exhaust system and the clean gas supply system may be at least partially disposed inside the RME 22. At least one of the gas exhaust system and the clean gas supply system may be disposed entirely inside the RME 22. One of the gas exhaust system and the clean gas supply system may be entirely disposed inside the RME 22, while the other may be partially disposed in the RME 22. One of the gas exhaust system and the clean gas supply system may be entirely disposed inside the RME 22, while the other may be disposed outside the RME 22.

The short stroke actuator 28, the long stroke actuator 30, the patterning device masking apparatus 32, the patterning device masking apparatus motion/control module 36, the radiation beam uniformity adjustment apparatus 38, the ITS flow supply 40, the G-mirror 42, the patterning device exchange apparatus 44, the pod 46, and/or the gas refreshing system 48 (which may comprise the gas exhaust system and/or the clean gas supply system) may be made from a metal, such as stainless steel. These components may comprise a dielectric coating on their surface, for example, in the form of a native oxide layer. These components are shown as hatched parts in Figure 2.

Each of the components described above may be used in a patterning device environment 20 which includes the reticle MA.

The EUV radiation beam 34 may interact with gas in the patterning device environment to form a plasma, containing active species which may interact with component surfaces to release contaminants. Additionally, energetic electrons may be formed through the interaction of EUV radiation beam 34 with electrons produced by the photoelectric effect (e.g. the incident EUV radiation beam 34 may interact with the reticle to release photoelectrons). The active species may comprise one or more of ions of the gas, free radicals of the gas, and/or energetic electrons.

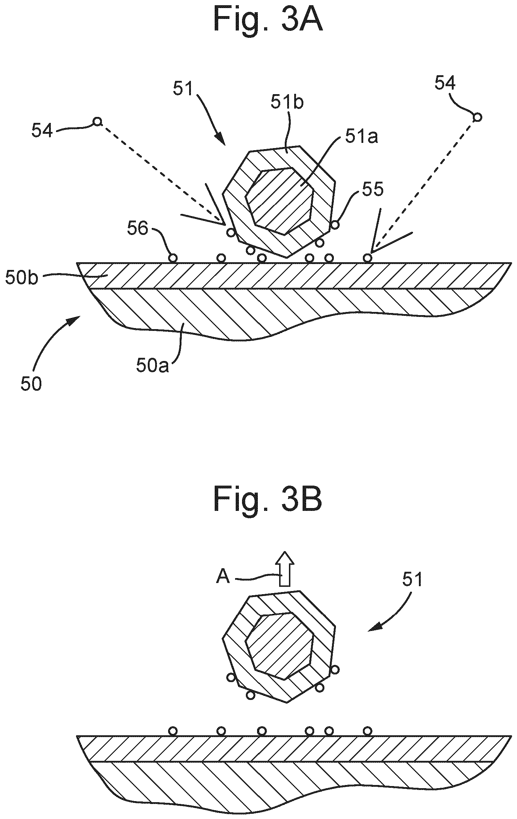

For example, energetic electrons incident on a component surface may lead to release of particles from the component, as explained with reference to Figures 3A and 3B.

Figure 3A shows a portion of a component 50, having an electrically conductive core 50a with a dielectric surface layer 50b. The component 50 is a generalization of a component of the lithographic apparatus that may comprise a dielectric layer, such as a component disposed in the RME 22 (e.g. the masking blade 33 or the gas refreshing system 48). The conductive core 50a may be made from steel, while the dielectric surface layer 50b may be a native oxide of the steel component. A particle 51 having a conducting core 51a and a dielectric surface layer 51b may reside on the surface of component 50. The particle 51 may be a part of the component 50 which has chipped away in use, or it may have been introduced into the lithographic apparatus during installation, for example. The particle 51 is a general representation of a contaminant particle which may be present on a component of the lithographic apparatus, and its source of origin is not limited to the two examples described. While both the component 50 and the particle 51 are shown as having a conductive core 50a/51a and a dielectric layer 50b/51b, the particle 51 and/or the component 50 may have no conductive core 51a and consist substantially of a dielectric material.

Energetic electrons 54 may cause release of particles 51 adhered to the component 50. For example, energetic electrons 54 incident on the component's dielectric surface layer 50b and on the particle's dielectric surface layer 51b lead to a charge build up on the respective surfaces. When the electrostatic repulsion force due to charge build-up exceeds binding force holding the particle 51 to the component 50, the particle 51 may be released from the surface as indicated by arrow A. This effect may be observed even if one or more of the component 50/particle 51 comprise a different morphology to that illustrated in Figures 3A and 3B. For example, the component 50 /particle 51 may have an interdiffusion layer between the conductive coating and the dielectric, or the component 50/particle 51 may be only partially covered with a dielectric layer. The component 50/particle 51 may respectively comprise different dielectric materials and/or each of their surfaces may comprise more than one dielectric. Once particle 51 is released from the component 50, the particle 51 may end up contaminating the reticle MA and/or other parts of the lithographic apparatus. Energetic electrons 54 may be the energetic electrons generated by the plasma, or energetic electrons from the EUV photoelectric effect.

A dielectric surface (e.g. component dielectric surface layer 50b or particle dielectric surface layer 51b) is a surface layer of the component 50 or particle 51 which comprises a dielectric material. When charge is incident on a dielectric surface material, the charge builds-up locally on the dielectric surface. This is in contrast to a situation in which charge is incident on a conductive coating, which dissipates charge uniformly over its surface.

As well as energetic electrons 54, the plasma may comprise active species such as gas ions or free radicals, that may cause release of particles 51 via mechanisms such as explosive fragmentation or adhesion reduction.

For example, gas free radicals (such as hydrogen free radicals, H*) may have a high diffusion coefficient in the some of the particles 51. The diffusion coefficient of gas free radicals in a material may depend on the material's composition. The H* radicals diffuse through the particle 51 and convert to a more stable state inside the particle 51 (e.g. H* may recombine to H₂). The stable gaseous phase (e.g. H₂ molecules) may be larger than the gas free radicals (e,g, H₂ molecules are larger than H*). The stable gaseous phase (e.g. H₂ gas) may generally have a lower diffusion coefficient than the gas free radical, for example, H₂ diffusion within the particle 51 may be lower than H*. Therefore, the gaseous phase (e.g. H₂) becomes trapped and forms high pressure bubbles inside the particle 51. This leads to a compressive stress build up within particle 51, which in turn is released in an explosive manner such that contaminant particles 51 or their fragments are released from the component 50. This may be referred to as explosive fragmentation.

As another example, H* also can react with the material of the particles (for example, forming metal hydrides, or etching (removing) halogens\non-metals from salts or ceramics) leading to stress-induced fragmentation. Generally, selective reactivity of H* or H⁺ to some of the elements of a particle (for example etching or uptake) will lead to a build-up of stress that can be both tensile and compressive, and that can eventually lead to explosive fragmentation.

Another example is that the particle interface (surface) may change under H*, leading to a reduction in the adhesion force that holds the particle 51 on the component surface (this may be referred to generally as adhesion reduction). That is, the effective density may reduce and/or the particles can develop nano-roughness. Both these factors will lead to reduction of adhesion of the particles 51 to the component 50 (i.e. reduction of van der Waals interaction).

Active species such as energetic electrons 54 are not necessarily generated by the plasma. For example, a reticle MA may release energetic electrons 54 in response to an incident radiation beam 34 due to the photoelectric-effect.

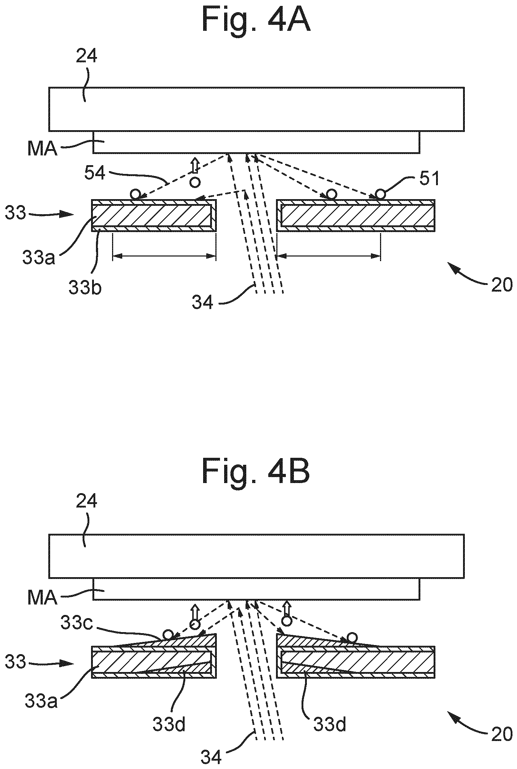

Possible side-effects of exposing of a patterning device environment 20 to a radiation beam 34 are explained with reference to the examples in Figures 4A and 4B. Figure 4A schematically illustrates release of particles 51 from masking blade 33. Figure 4B schematically illustrates the ageing effects which may be exhibited by components of the patterning device environment after prolonged use, i.e. the effects of ageing.

Figure 4A schematically illustrates a part of a reticle mini environment 22, comprising a reticle MA, clamp 24 and masking blade 33. The masking blade 33 comprises a conductive core 33a and dielectric surface layer 33 (for example, the conductive core 33a may be steel and the dielectric surface layer 33b may be the native oxide). When the radiation beam 34 is incident on the reticle MA, energetic electrons 54 are released. The energetic electrons 54 are incident on the dielectric surface layer of masking blade 33b, causing release of particles 51 from the masking blade 33 towards the reticle MA. The particles 51 may then contaminate the reticle MA or other parts of the lithographic apparatus.

Figure 4B schematically illustrates the reticle mini environment 22 of Figure 4A after prolonged exposure to a radiation beam 34. The radiation beam 34 may generate active species by one or more of the mechanisms described above, e.g. by propagating in low pressure hydrogen and generating active species. Active species may interact with the reticle MA or other exposed surfaces (e.g. ceramic surfaces) and release volatile contaminant molecules, for example hydrides. Such volatile contaminant molecules can be physisorbed on RME components, such as reticle masking blades. Being physisorbed means that the volatile compounds become attached to a surface through adsorption. Some of physisorbed molecules on RME components may dissociate and oxidize in presence of high energy electrons or scattered EUV photons and may form dielectric layers. For example, an aged masking blade 33 may comprise a native oxide layer and an additional dielectric layer from the dissociated and/or oxidized contaminants. Furthermore, regions of the masking blade 33 which are exposed (e.g. directly exposed) to the radiation beam 34 develop a thicker dielectric layer due to deeper oxidation of the steel under the influence of incident radiation beam 34. This additional thickness of the dielectric layers 33d and 33c promotes further release of particles 51 when energetic electrons 54 are incident. A thicker dielectric layer is generally undesirable as is promotes particle release by incident active species such as energetic electrons 54.

While release of particles 51 and the development of thicker dielectric layers 33c, 33d is described with reference to a masking blade 33, one or more of these effects may occur with any component of the lithographic apparatus, especially components in a patterning device environment 22. These undesirable effects may occur in other environments of the lithographic apparatus, such as in the vicinity of substrate W.

Providing a conductive coating on the outer surface of a component 50 (such as a masking blade 33 or gas refreshing system 48) reduces charge build-up as any incident charge spreads out over the surface of the component, and/or at least reduces or prevents reticle defectivity. A conducting coating is beneficial for a component with an existing dielectric layer, such as native oxide. A conducting coating is also beneficial for a component with the deposited or grown dielectric layer 33c, 33d as described with reference to Figure 4A and 4B. Thus, it may be desirable to provide a lithographic apparatus with components having a conductive coating.

Existing lithographic apparatuses may comprise components which do not have a conductive coating. While it is possible to replace these existing components with components having a conductive coating, replacing of existing components is a cumbersome process which may require the lithographic apparatus to be taken offline. Furthermore, even if a lithographic apparatus is provided with components having a conductive coating, the conductive coating may degrade over time. The conductive coating may degrade over time for example due to molecular contamination physisorption, dissociation and/or oxidation.

According to the present invention, there is provided a method of depositing a conductive coating to a component of the lithographic apparatus in situ. Applying the conductive coating in situ means that existing components may have a conductive coating applied thereto without taking the lithographic apparatus offline. Furthermore, the method can be used to reapply a conductive coating once a conductive coating has degraded.

According to the present invention, a carrier member having a precursor material disposed thereon is provided in the lithographic apparatus. The carrier member is heated to form a vapor of the precursor material. The precursor material may be sublimated, i.e. heated so that it changes physical state from a solid to a vapor. Alternatively, the precursor material may undergo an intermediate liquid state, before being vaporized to form the precursor vapor. The precursor vapor is then condensed onto the component being coated so that a conductive coating is formed. The component being coated with a conductive coating may be kept at lower temperature than the carrier member to promote precursor vapor condensation on the component.

Once the precursor vapor condenses on the component being coated, the conductivity of the formed precursor layer may increase further due to interaction with lithographic apparatus environment. For example, the formed conductive coating can partially or fully reduce in EUV hydrogen plasma environment. Stability of the coating may increase due to partial or full reduction in EUV hydrogen plasma environment, e.g. after partial or full reduction the precursor vapor may become less volatile. The conductive coating formed on a component may also at least partially coat any contaminant particles present on the component. A conductive coating on contaminant particles can reduce concentration of charge deposited by energetic electrons and thus can suppress particle release by energetic electrons.

In an embodiment, the carrier member may be heated by the radiation beam 34, for example an EUV radiation beam. This may be a particularly convenient way of heating the carrier member, as a lithographic apparatus may already be configured to supply radiation beam 34. Additionally, or alternatively, the carrier member may be heated by other means, such as a laser. The laser could be configured to supply a radiation beam of ultraviolet radiation, visible radiation or infrared radiation. Additionally, or alternatively, the carrier member may be heated by resistive heating. Resistive heating may be achieved by providing a resisting heating element in thermal contact with the carrier member, or having a resistive element integrated into the carrier member.

The method according to the present invention may be used to apply a conductive coating to components of reticle mini environment 22 or even components in the patterning device environment 20. This may be particularly helpful for preventing release of contaminant particles and preventing the thickening of the dielectric surface layer of components disposed in the reticle mini environment 22, which is described with reference to the example on Figures 4A and 4B. However, the method of the present invention may be used in other regions of the lithographic apparatus, such as in the vicinity of the substrate W.

In an embodiment, the method may be used to apply a conductive coating to components of the RME 22 such as the masking blade 33, the gas refreshing system 48 and/or the radiation beam uniformity adjustment apparatus 38. The conductive coating may be applied to all components in a field of view of the precursor material. The conductive coating may be applied selectively to only some of the components. The conductive coating may be applied to a portion of the component.

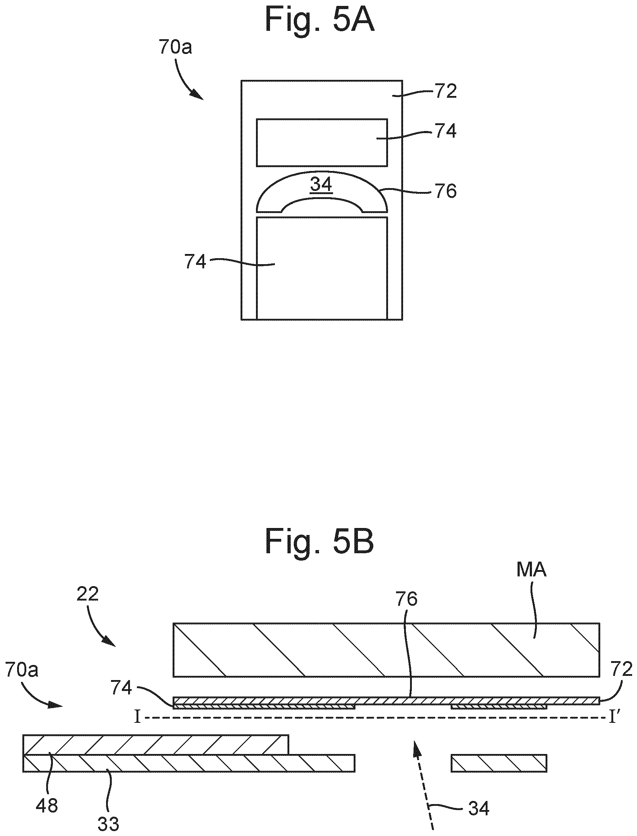

An embodiment of the carrier member 70a is described with reference to Figures 5A and 5B. Figure 5A shows a cross-sectional view of a carrier member 70a, taken along line I-I' in Figure 5B. Figure 5B shows a cross section of a reticle mini environment 22 with a carrier member 70a disposed therein.

In an embodiment, the carrier member 70a may be attached to a reticle MA, as shown in Figure 5A for example. Alternatively, the carrier member 70a may be attached to a device which is functionally similar to the reticle MA. A device functionally similar to the reticle MA means a device that may cooperate with clamp 24 in a similar way as the reticle MA, but unlike the reticle MA it is not configured to pattern a radiation beam 34 (clamp 24 not shown in Figure 5B). Alternatively, the carrier member 70a may be attached directly to the clamp 24. Accordingly, the carrier member 70a may be held in the patterning device environment 22 in a way that does not require any modifications or any substantial modifications to the lithographic apparatus. Optionally, the carrier member may be supported by mechanical actuators disposed on clamp 24 or adjacent to clamp 24 (mechanical actuators not shown). The carrier plate 72 may be mounted on the clamp 24 or the reticle MA with spring elements, to account for any thermal expansion of the carrier plate 72 during heating and cooling of the carrier plate 72.

Providing the carrier member 70a inside RME 22 in this way enables the carrier member 70a to be heated by radiation beam 34, meaning it is not necessary to provide further additional heating means to heat the carrier member 70a. However, the carrier member 70a may be heated in another way, such as by alternative or additional heating means comprising a laser or a resistive heating element. The carrier member 70a may be transferred to the RME by the patterning device exchange apparatus 44 (described with reference to Figure 2). The carrier member could be supported and shielded by a pod 46, in a similar manner to reticle MA (described with reference to Figure 2).

The carrier member 70a may comprise a carrier plate 72 with precursor material 74 disposed thereon. The carrier member 70a may be disposed in the lithographic apparatus so that the precursor material 74 faces the component to be coated. The precursor material 74 may be selectively applied to portions the carrier plate 72 in a pattern, so that that the precursor vapor is created in regions facing regions of components which should be coated. By placing the precursor material 74 in this way, the propagation of vapor (by diffusion and convention) is guided towards the components to be coated. This means that the vapor condenses in regions of interest and the conductive coating is preferentially formed where it is desired. Accordingly, deposition of the conductive coating to other regions of the lithographic apparatus may be avoided. The lithographic apparatus and the carrier member 70a may be configured to prevent deposition of the conductive coating outside the regions of interest, as described later.

In the example shown in Figure 5B, the precursor material 74 is applied to the carrier plate 72 of carrier member 70a so that the carrier plate 72 faces the gas refreshing system 48 and the masking blade 33.

When the carrier plate 72 is irradiated by radiation beam 34, the carrier plate 72 is heated. The carrier plate 72 conducts the heat from the irradiated portion to non-irradiated portions, causing heating and evaporation of the precursor material 74. The vapor diffuses towards the components in the vicinity of the carrier plate 72 and condenses on the components to form a conductive coating.

Figure 5A shows that the radiation beam 34 irradiates a portion 76 of the carrier member 70a. The shape of the irradiated portion 76 may be determined by the position of the masking blade 33 and the radiation beam uniformity adjustment apparatus 38, which determine the shape of the radiation beam 34 cross-section.

The carrier plate 72 may be selected to have sufficiently high thermal conductivity to enable reasonably fast heat transfer from irradiated portion 76 to non-irradiated portions (such as portions having the precursor material 74 disposed thereon). For example, the carrier plate 72 may have a thermal conductivity of at least 50 Wm⁻¹K⁻¹, or preferably more than 100 Wm⁻¹K⁻¹. As the carrier plate 72 has a relatively high thermal conductivity, it readily reaches a uniform temperature when the radiation beam is irradiated on the irradiated potion 76. The carrier plate 72 may be selected so that it does not deform or melt when radiation beam 34 is incident on it. For example, the carrier plate 72 may be selected so that it withstands temperatures of 600 K or more. The carrier plate 72 may be made from a metal, such as molybdenum, tungsten, silver, aluminum, or alloys thereof. For example, one or more of the metals may be alloyed with one or more of oxygen, nitrogen or carbon. The carrier plate 72 may be made from a ceramic or a semiconductor, such as polycrystalline silicon, silicon carbide, molybdenum silicide nitride, or aluminum nitride. It may be preferable for the carrier plate 72 to have a thickness of at least 0.1 mm, or preferably more than 1 mm. The carrier plate 72 is preferably configured so that it does not chemically alter the precursor material 74, e.g. the carrier plate 72 is made from a material which does not undergo a chemical reaction with the precursor material 74 or with EUV plasma (i.e. plasma generated by interaction of the radiation beam 34 with the gas in the environment). At least a portion of the carrier plate 72 facing the reticle MA may be covered with a coating having an emissivity of less than 0.3, to reduce heat exchange between the carrier plate 72 and the surrounding components. The reticle MA, or at least a portion thereof facing the carrier plate 72, may be covered with a coating having an emissivity of less than 0.3. This may reduce heat loss via radiation.

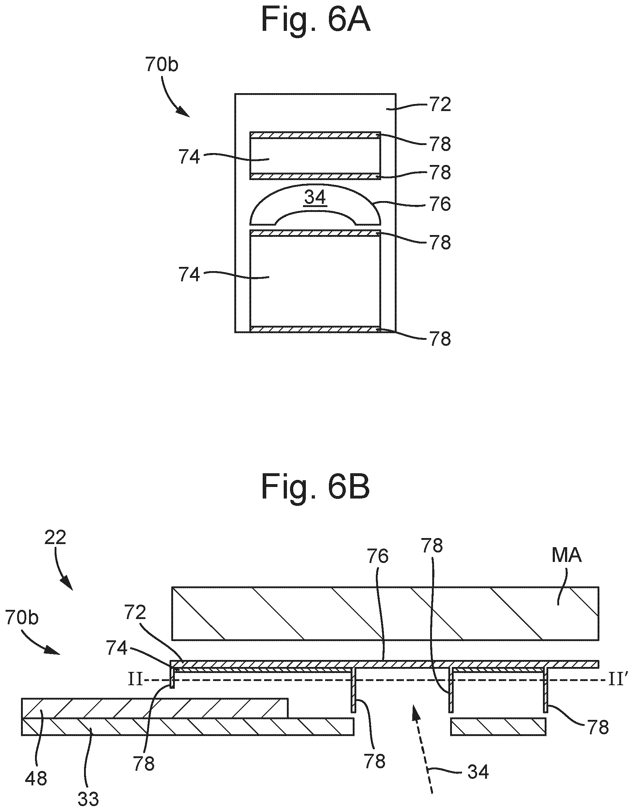

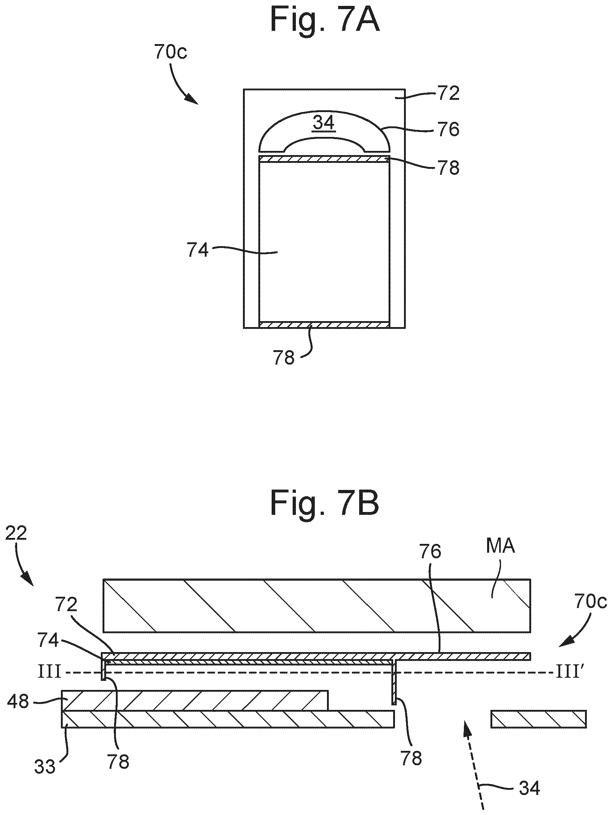

The carrier plate 72 may have a shape that is configured to guide the precursor vapor to predetermined regions of the components, so that the conductive coating is preferentially deposited on the desired regions of the components. For example, the carrier plate 72 may have at least one fin, which will be described with reference to Figures 6A, 6B, 7A and 7B. Each of the at least one fins may protrude away from the carrier plate 72. For example, each of the at least one fin may protrude towards a component being coated. One or more of the at least one fin may extend perpendicularly or substantially perpendicularly from the surface of the carrier plate 72 having the precursor material disposed thereon. A fin may be described as a flange, i.e. a flat surface sticking out from the carrier plate 72. Figures 6A, 6B, 7A and 7B depict some of the possible shapes of a carrier member which may be provided instead of carrier member 70a described with reference to Figures 5A and 5B.

Figure 6A shows a cross-sectional view of a carrier member 70b, taken along line II-II' in Figure 6B. Figure 6B shows a cross section of a reticle mini environment 22 with a carrier member 70b disposed therein. Figure 7A shows a cross-sectional view of a carrier member 70c, taken along line III-III' in Figure 7B. Figure 7B shows a cross section of a reticle mini environment 22 with a carrier member 70c disposed therein.

Fins 78 may extend from the carrier plate 72 to guide the precursor vapor toward predetermined portions of the masking blade 33 and the gas refreshing system 48. The fins 78 may be of different length/thickness depending on the desired location of the applied coating. The precursor vapor may propagate to the components via convection and/or diffusion, so the fins 78 may act as channels which guide the vapor to predetermined regions of the components being coated.

Figures 6A and 6B depict an embodiment of a carrier member 70b which is configured to apply a conductive coating to parts of a masking blade 33 disposed either side of the either side of the irradiated portion 76, as well as the gas refreshing system 48. Figures 7A and 7B depict an embodiment of a carrier member 70c which is configured to apply a conductive coating to parts of a masking blade 33 disposed on one side the irradiated portion 76, as well as to parts of the gas refreshing system 48. The number of fins 78 and their dimensions may be selected so that the conductive coating is applied only in the desired regions. The fins 78 may be configured so the conductive coating is not applied to component regions where presence of a conductive coating is not desired. During the coating method, the fins 78 may be at least partially coated with the precursor material.

In Figures 5A, 5B, 6A, 6B, 7A, 7B the portion of gas refreshing system 48 shown in the figure may represent at least a portion of the gas exhaust system and/or a portion of the clean gas supply. In other words, the conductive coating may be applied to at least a portion of one or more of the gas exhaust system, the clean gas supply, or other constituent parts of the gas refreshing system 48.

Instead of a carrier plate 72, the carrier member may comprise a carrier membrane 84 supported by a frame 82. The carrier membrane 84 and frame 82 may be functionally similar to a pellicle, which may be used to protect a reticle MA from contamination during a lithographic process. The precursor material 74 may be provided on the carrier membrane 84 as a layer of adhered particles or as a coating. Optionally, the precursor material 74 may be embedded in the membrane 84. The frame 82 may be configured so that it may be attached to reticle MA or clamp 24 (for example, the frame 82 may be attached to the reticle MA using a pellicle mounting interface). When the carrier membrane 84 is heated, the precursor material 74 is vaporized and is deposited on a component of the lithographic apparatus as a conductive layer.

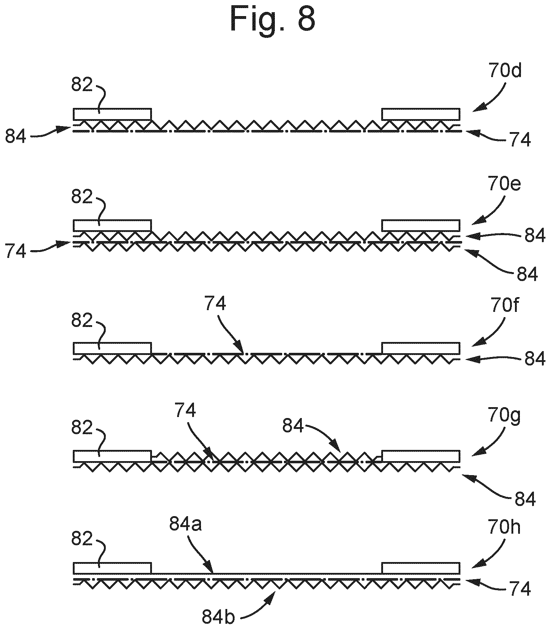

Figure 8 schematically depicts some of the possible configurations of the carrier member comprising a carrier membrane 84. For example, carrier member 70d comprises carrier membrane 84 supported by frame 82, with precursor material 74 disposed on the carrier membrane 84. Carrier member 70e comprises two carrier membranes 84 with a layer of precursor material 74 disposed in-between. Carrier members 70f and 70g show further alternatives way of carrying precursor material 74 on carrier membrane 84. As schematically depicted by carrier member 70h, the precursor material 74 may be provided between membranes of different types (e.g. a first carrier membrane 84a and a second carrier membrane 84b).

Carrier membrane 84 may comprise a dense film or a porous film. A porous film carrier membrane 84 may comprise carbon nanotubes or boron nitride nanotubes. A dense film carrier membrane 84 may comprise a film of silicon or molybdenum silicate and/or silicon nitride. The carrier membrane 84 may have a thickness of less than 10 µm, and preferably less than 1 µm.

The carrier membrane 84 may have an EUV transmission of less than 50%, or preferably less than 90% or even more preferably less than less than 99%. The carrier membrane 84 may have an emissivity of less than 0.3, to reduce heat exchange between the carrier membrane 84 and the surrounding components (such as the reticle that the carrier member is attached to). At least a portion of the carrier membrane 84 may be covered with a coating having an emissivity of less than 0.3, to reduce heat exchange between the carrier membrane 84 and the surrounding components. Carrier membrane 84 may have a relatively low thermal conductivity (for example, if compared to the thermal conductivity of the carrier plate 72).

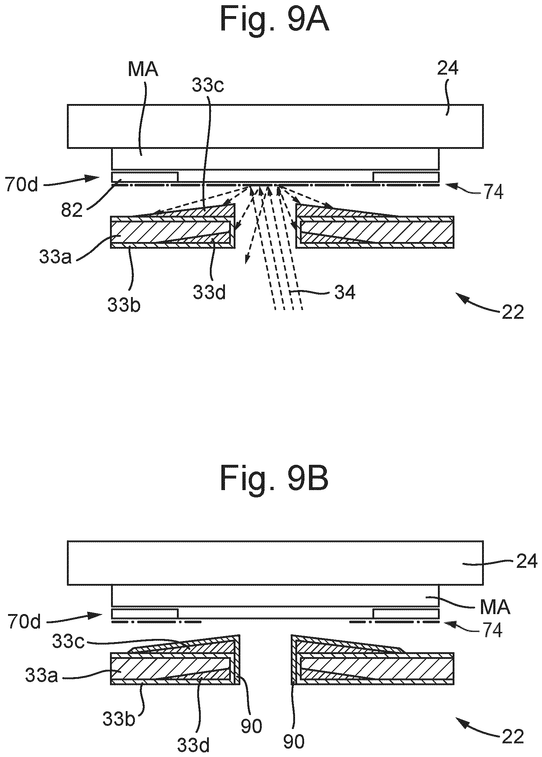

Figures 9A and 9B schematically depict RME 22 comprising clamp 24, reticle MA and masking blade 33, with a carrier member 70d attached to reticle MA. The carrier member 70d comprises a carrier membrane 84 with precursor material 74 disposed on its surface, so that the precursor material faces the masking blade 33. When radiation beam 34 is incident on the carrier membrane 84, the precursor material 74 is vaporized in the region irradiated by the radiation beam 34. The precursor vapor is then reduced in the atmosphere of RME 22 to form a conductive coating 90 on the surface of the masking blade 33 (which may have dielectric layers 33b, 33c, 33d disposed thereon as described with reference to Figure 4B). As the carrier membrane 84 has a relatively low thermal conductivity, heating is localized in the irradiated portion of the carrier membrane 84 so that the precursor material 74 is vaporized in the irradiated regions. This is in contrast to embodiments comprising carrier plate 72, where the precursor material may be vaporized from non-irradiated regions of the carrier plate 72.

In some applications, it may be preferable to use a carrier member comprising a carrier membrane 84. A carbon nanotube or boron nitride nanotube carrier membrane 84 may support higher temperatures than a molybdenum carrier plate 72 due to suppressed heat conduction in-plane of the membrane. For example, a carbon nanotube membrane may support temperatures of about 900K or even higher whereas a molybdenum carrier plate 72 may only support temperatures of about 600K. A carrier membrane 84 may be more suitable for less volatile precursor materials.

The precursor material 74 may be applied to the carrier plate 72 or the carrier membrane 84 as a coating, as particles or in another appropriate way. The precursor material 74 may be adhered to the carrier member (e.g. to the carrier plate 72 or the carrier membrane 84) by surface adhesion, e.g. by van der Waals forces.

When the precursor material 74 is heated, it vaporizes (i.e. it forms a vapor). Preferably, the precursor material 74 sublimates, i.e. it changes physical state directly from a solid to a vapor. It will be appreciated that the sublimation point for a substance may vary with pressure and temperature. Therefore, the precursor material 74 may be selected so that it sublimates at the gas pressure within the lithographic apparatus (for example, the gas pressure in the reticle mini environment 22) when it is heated.

The gas pressure and/or flow of gas may be controlled during the conductive coating deposition. For example, the gas pressure in the patterning device environment 20 (including the RME 22) and/or the flow of gas may be controlled so that the precursor vapor is guided to portions of the components where deposition of the conductive coating is required. For example, the gas refreshing system 48 may be configured to supply and/or evacuate gas (such as hydrogen) in a manner that guides the precursor vapor to regions of components where a conductive coating is desired. Other components of the lithographic apparatus that are configured to supply/extract gas (e.g. from the patterning device environment 20) so that gas is supplied/extracted to promote formation of the conductive coating in the regions of interest and/or prevent formation of the conductive coating outside of those regions. For example, it may be preferably to avoid forming a conductive coating on G-mirror 42. Controlling of gas flow may mean controlling the gas flow rate, direction of the gas supply, controlling gas pressure and/or gas partial pressure. During application of a conductive coating, it may be preferable to prevent any sideways movement of the precursor vapor (e.g. prevent movement of the vapor in the plane of the carrier plate 72 or carrier membrane 84).

The conductive coating is formed when the precursor vapor is deposited on the component. Preferably, the precursor vapor is reduced after the deposition by the gas or gas plasma. For example, when coating components of the patterning device environment which contains low-pressure hydrogen, a radiation beam 34 may excite a plasma of hydrogen. The precursor vapor may be reduced by the hydrogen plasma to form a conductive or at least a more conductive coating on the component's surface. When the carrier member is heated by radiation beam 34, the same radiation beam 34 may form a plasma of gas in the patterning device environment 20. The reduction of the precursor on a component by plasma or other active species may happen on a timescale that is longer than the deposition of the precursor from vapor phase.

The precursor material may be a compound which may be reduced in the presence of a reducing atmosphere (e.g. hydrogen gas or hydrogen plasma) to form a conductive coating. For example, the precursor material may comprise at least one metal oxide and/or at least one metal hydroxide. The at least one metal oxide may be selected from a list containing molybdenum oxide, ruthenium oxide, iridium oxide, rhenium oxide, niobium oxide and tungsten oxide. For example, the precursor material may comprise one or more of MoOs, RuO₄, IrO₃, ReO₄, NbO, WO₃. The at least one metal hydroxide may be selected from a list containing molybdenum hydroxide, ruthenium hydroxide, iridium hydroxide, rhenium hydroxide, niobium hydroxide and tungsten hydroxide.

For example, MoOs may be used as the precursor material. When it vaporized and placed into a reducing atmosphere (e.g. an atmosphere of hydrogen gas or a plasma of hydrogen gas) in accordance with the method of the present invention, the condensed MoOs is later reduced by hydrogen plasma to form a coating of MoO₂. MoO₂ is highly electrically conducting, compared to MoOs. Other oxides and mixes of oxides may be collateral products of the reduction, so that average chemical composition of the coating may be MoOₓ where 0<x<3, and preferably 0<x<2.

The carrier member may continue to be heated until precursor coating of the required thickness is formed. For example, the carrier member may be heated briefly so that one monolayer of the coating is formed. The carrier member may be heated for longer (such as 100 seconds) so that a thicker coating is formed, such as a coating of up to 10 nm or even greater. The method of the present disclosure may result in a coating having a uniform thickness. The coating electrical conductivity reach the target value after some time after the deposition.

The conductive coating preferably has a conductivity which allows any incident electrical charge from EUV plasma or EUV photo-effect to be uniformly dissipated over the conductive coating within a limited time. For example, the conductive coating may have a sheet resistance of less than 10⁹ Ohm per square.

A carrier member comprising a carrier plate (such as carrier member 70a, 70b, 70c) may be particularly well-suited for applying a conductive coating to the masking blade 33 or the gas refreshing system 48. The carrier plate 74 of carrier member 70a, 70b, 70c may be configured to vaporize a precursor from portions of the carrier member 70a, 70b, 70c that are not irradiated, and the fins 78 may selectively guide the precursor vapor toward the components being coated. As the carrier plate 74 may be configured to reach temperatures of up to about 600K (which may occur under irradiation with the EUV radiation beam 34), the precursor may be selected such that it has sufficient vapor pressure at such a temperature to provide sufficient flux of precursor vapor towards the component.

A carrier member comprising a carrier membrane 84 (such as carrier members 70d, 70e,70f, 70g, 70h) may be particularly well-suited for applications where a precursor with reduced volatility is required, because the carrier membrane 84 may be configured to reach relatively high temperatures of about 900 K, or higher. However, embodiments of a carrier member comprising a carrier membrane 84 may provide less control over the vapor flow, since the source of the precursor vapor remains within EUV irradiated spot 34, even if the carrier membrane is moved with respect to EUV irradiated spot 34.

According to the present invention, there is provided a lithographic apparatus configured to carry out the method of the present invention. For example, the patterning device actuator discussed with reference to Figure 2 may be configured to move a reticle MA during a lithographic process, but when a carrier member is provided on the reticle MA the patterning device actuator may be configured to keep reticle MA stationary. The carrier member may comprise an optimum irradiation area, which when irradiated with radiation beam 34, provides a precursor vapor in a pattern that selectively condenses on the components of interest. Accordingly, the lithographic apparatus may be configured to position the carrier member so that irradiated area 76 coincides with the optimum irradiation area. The lithographic apparatus may be further configured to move its components (e.g. the masking blades 33, the gas refreshing system 48, the radiation beam uniformity adjustment apparatus 38) so that the conductive coating is applied only to regions of interest. For example, the position of the radiation beam uniformity adjustment apparatus 38 and/or masking blade 33 may be adjusted so that the radiation beam 34 selectively illuminates predetermined areas of the carrier member (for example, so that the irradiated area 76 coincides with the optimum irradiation area). The gas exhaust system and/or the clean gas supply system may be moved relative to the so that the conductive coating is applied to the regions of interest.

According to the present invention, there is provided a method of maintaining components of a lithographic apparatus. When the level of contaminant particles (e.g. contaminant particles deposited on reticle MA during a lithographic process) exceeds a predetermined threshold, it is determined that the conductive coating of components has deteriorated. The method according to the present invention is then used to provide a conductive coating to components of the lithographic apparatus.

Specific examples of the method of the present invention are illustrated in Example 1 and Example 2. In Example 1, a carrier member comprising a carrier plate is used. In Example 2, a carrier member comprising a carrier membrane is used.

### [Example 1]

According to an embodiment of the invention, precursor material comprising MoOs may be provided on a carrier plate. When heated to T=600K, the precursor material vaporises to form a precursor vapor of partial pressure P₁, e.g. pressure of 1 * 10⁻⁶ mbar. When heated to 600 K, the precursor may vaporise and the precursor vapor may propagate to the masking blade 33 and/or radiation beam uniformity adjustment apparatus 38 at rate W₁. Precursor vapor flow rate W₁ may be obtained by multiplying the number of molecules per unit volume (n, obtainable from the ideal gas law) by the root mean square speed of the MoOs molecules (v), as shown in the expression below. In the expression below, M_{MoO3} is the molecular weight of MoOs and k is the Boltzmann constant (1.38 JK⁻¹). In the expression below, it is assumed that all of the precursor vapor is used to form the coating (i.e. the transport efficiency, TE, is 1). $W = \frac{nv}{4} \times TE = \frac{{P}_{1}}{kT} \times \frac{{\left(\frac{3 kT}{{M}_{{MoO}_{3}}}\right)}^{0.5}}{4} \times 1 \approx 4 \times {10}^{18} {m}^{- 2} {s}^{- 1}$

At a precursor flow rate of 4*10¹⁸ m⁻²s⁻¹ , the precursor molecules MoOs each having diameter D_{MoO3} (approximately 0.6 nm) the coating may grow at a rate, Q. $Q ≅ {\left({D}_{{MoO}_{3}}\right)}^{3} \times W ≅ 1 nm / s$

At rate Q=1nm/s, a coating of thickness 1-10 nm (which is sufficiently thick to achieve sufficiently high conductivity, at least after partial reduction) may be deposited in 1-10 seconds. In practice, additional time may be required to heat the carrier plate. For example, to achieve a uniform temperature profile in a tungsten plate of area 100 cm² and thickness 1 mm when it is irradiated with a 100 W radiation beam, approximately 80 second may be required (assuming negligible heat is lost via radiation). This is confirmed with the following calculation, where tₕₑₐₜ - time to heat plate to 600 K from a room temperature of 300 K, h - carrier plate thickness, A - carrier plate area, Cₚ - carrier plate specific heat capacity, ρ - gas density, ΔT - carrier plate temperature change (difference between initial temperature and final temperature) and P - radiation beam power: ${t}_{heat} = h \times A \times {C}_{p} \times ρ \times \frac{Δ T}{P} = 1 mm \times 100 {cm}^{2} \times 0.13 {JK}^{- 1} {g}^{- 1} \times 20 {gcm}^{- 3} \times \frac{300 K}{100 W} ≅ 80 s$

### [Example 2]

According to an embodiment of the invention, precursor material comprising MoOs may be provided on a carrier membrane. When heated to T=900K, the precursor material vaporises to form a precursor vapor of partial pressure P₂, e.g. pressure of 1 * 10⁻² mbar. The carrier membrane may exhibit worse control of precursor vapor propagation than the carrier plate in Example 1, so the transport efficiency for a carrier membrane may be 0.1 or even 0.01 (i.e. only 1-10% of the precursor vapor is used to form a coating). Even if a transport efficiency of 0.01 is assumed, the flow rate W₂ which may be achieved by using a carrier membrane is 4*10¹⁹ m⁻²s⁻¹ (using the same calculation as in Example 1).

While the method of the present invention is described predominantly with reference to components in the patterning device environment 20, this method may be used in other regions of the lithographic where it may be helpful to apply a conductive coating in situ. For example, the method of the present invention may be used to apply a conductive coating to components in the vicinity of substrate W. For example, the carrier member may be a device functionally similar to substrate W which allows it to be supported by a substrate table WT. When irradiated with radiation beam B', the precursor material disposed on the carrier member may evaporate and condense on components in the substrate environment.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Embodiments of the present disclosure can be further described by the following clauses:
1. A method for applying a conductive coating to a component of a lithographic apparatus, comprising:
   providing a carrier member in the lithographic apparatus, wherein a precursor material is disposed on the carrier member,
   heating the carrier member to form a vapor of the precursor material,
   condensing the precursor vapor onto the component to form the conductive coating.
2. The method according to clause 1, wherein the heating is provided to the carrier member with a radiation beam.
3. The method according to clause 2, wherein the radiation beam is a beam of extreme ultraviolet radiation, ultraviolet radiation, visible radiation or infrared radiation.
4. The method according to any one of clauses 1 to 3, wherein heating is provided to the carrier member via resistive heating.
5. The method according to any of the preceding clauses, wherein the precursor material is disposed on a portion of the carrier member that faces the component to be coated.
6. The method according to any of the preceding clauses, wherein the component and the carrier member are each disposed in a reticle mini environment area of the lithographic apparatus.
7. The method according to any of the preceding clauses, wherein the component comprises one or more of a reticle masking blade, a gas supply system, a gas exhaust system and a beam uniformity adjustment apparatus.
8. The method according to any of the preceding clauses, wherein the lithographic apparatus comprises a clamp configured to hold a reticle in normal use, wherein the carrier member is attached to the reticle or to the clamp, and/or the carrier member is supported by mechanical actuators.
9. The method according to any of the preceding clauses, wherein the carrier member comprises a carrier plate which is attached to the clamp or to the reticle.
10. The method according to any of the preceding clauses, wherein the carrier plate comprises one or more of molybdenum, tungsten, silver, aluminum, silicon, oxygen, nitrogen, carbon.
11. The method according to any of the preceding clauses, wherein the carrier plate has a thermal conductivity of at least 50 Wm-1K-1, preferably more than 100 Wm-1K-1.
12. The method according to any of the preceding clauses, wherein the carrier plate has a thickness of more than 0.1 mm, preferably more than 1 mm.
13. The method according to any one of clauses 9 to 12, wherein the precursor vapor is guided by at least one fin integrated into the carrier plate, the at least one fin protruding from the carrier plate towards the component.
14. The method according to clause 13, wherein the at least one fin restricts propagation of the precursor vapor to areas other than a predetermined area of the component.
15. The method according to any one of clauses 1 to 8, wherein the carrier member comprises a carrier membrane supported by a frame.
16. The method according to clause 15, wherein frame is attached to the reticle using a pellicle mounting interface.
17. The method according to clauses 9 to 16, wherein at least part of a surface of the carrier member facing the reticle is coated with a coating having an emissivity of less than 0.3.
18. The method according to any one of clauses 9 to 16, wherein at least a portion of the reticle facing the carrier member is coated with coating having an emissivity of less than 0.3.
19. The method according to any of clauses 15 to 18, wherein the carrier membrane has a thickness of less than 10 µm, preferably less than 1 µm.
20. The method according to any of clauses 15 to 19, wherein the carrier membrane comprises carbon nanotubes or boron nitride nanotubes.
21. The method according to any of the preceding clauses, wherein the precursor material comprises at least one metal oxide.
22. The method according to clause 21, wherein the at least one metal oxide is selected from one of molybdenum oxide, ruthenium oxide, iridium oxide, rhenium oxide, niobium oxide and tungsten oxide.
23. The method according to any of the preceding clauses, wherein the precursor material comprises one or more of: MoOs, RuO₄, IrO₃, ReO₄, NbO, WO₃.
24. The method according to any of the preceding clauses, wherein the precursor material comprises at least one metal hydroxide.
25. The method according to clause 24, wherein the at least one metal hydroxide is selected from one of molybdenum hydroxide, ruthenium hydroxide, iridium hydroxide, rhenium hydroxide, niobium hydroxide and tungsten hydroxide.
26. The method according to any of the preceding clauses, wherein the precursor material is selectively applied to regions of the carrier member which face the component during the conductive coating application.
27. The method according to any of the preceding clauses, wherein the carrier member is positioned by the lithographic apparatus such, that coating is applied primarily to the defined areas of the component or components in the reticle mini environment.
28. The method according to any of the preceding clauses, wherein condensed precursor vapor on a component is reduced by hydrogen gas or hydrogen plasma to form the conductive coating.
29. The method according to any of the preceding clauses, wherein the carrier member is irradiated with the radiation beam for at least 100 seconds.
30. The method according to any of the preceding clauses, further comprising guiding the precursor vapor to selectively condense on a predetermined area of the component.
31. The method according to any of the preceding clauses, wherein the precursor vapor is guided by control of pressure and/or gas flow.
32. The method according to any of the preceding clauses, wherein the carrier member is removed from the lithographic apparatus after the conductive coating is applied.
33. The method according to any of the preceding clauses, wherein the conductive coating has a thickness of at least one atomic monolayer, and optionally, up to 100 nm.
34. The method according to any of the preceding clauses, wherein the conductive coating has a sheet resistance of less than 109 Ohm per square.
35. A method of maintaining a component of a lithographic apparatus, comprising:
   monitoring level of particles added to a reticle during exposure, and
   performing the method of any one of the preceding clauses when the level of particles added to a reticle during exposure exceeds a predetermined threshold.
36. A reticle mini environment component comprising a conductive coating produced by the method of any one of clauses 1 to 35.
37. A carrier member for applying a conductive coating to components of a lithographic apparatus, the carrier member comprising a carrier plate or a carrier membrane having a melting point of more than 600 K and comprising a precursor material disposed thereon.
38. The carrier member according to clause 37, wherein the precursor material comprises at least one metal oxide.
39. The carrier member according to clause 38, wherein the at least one metal oxide is selected from one of molybdenum oxide, ruthenium oxide, iridium oxide, rhenium oxide, niobium oxide and tungsten oxide.
40. The carrier member according to any of clauses 37 to 39, wherein the precursor material comprises one or more of: MoOs, RuO₄, IrO₃, ReO₄, NbO, WO₃.
41. The carrier member according to clause 37, wherein the precursor material comprises at least one metal hydroxide.
42. The carrier member according to clause 41, wherein the at least one metal hydroxide is selected from one of molybdenum hydroxide, ruthenium hydroxide, iridium hydroxide, rhenium hydroxide, niobium hydroxide and tungsten hydroxide.
43. The carrier plate according to any of clauses 37 to 42, wherein the carrier plate comprises one or more of molybdenum, tungsten, silver, aluminum, silicon, oxygen, nitrogen, carbon.
44. The carrier plate according to any of clauses 37 to 43, wherein the carrier plate has a thermal conductivity of at least 50 Wm⁻¹K⁻¹, preferably more than 100 Wm⁻¹K⁻¹.
45. The carrier plate according to any of clauses 37 to 44, wherein the carrier plate has a thickness of more than 0.1 mm, preferably more than 1 mm.
46. The carrier membrane according to any of clauses 37 to 42, wherein the carrier membrane has a thickness of less than 10 mm, preferably less than 1 um, and the carrier membrane optionally comprises carbon nanotubes or boron nitride nanotubes.
47. The carrier member according to any of clauses 37 to 46 wherein the precursor material is provided on predetermined regions of the carrier member, facing the component in reticle mini environment.
48. The carrier member according to any of clauses 37 to 47, comprising at least one fin configured to guide propagation of precursor vapor from the carrier member to the component in reticle mini environment.
49. A lithographic apparatus configured to perform the method of any one clauses 1 to 34, wherein the apparatus is configured to control the pressure and flow of gas to the components of the lithographic apparatus to guide the precursor vapor to predetermined areas of the reticle mini environment.
50. The lithographic apparatus according to clause 49, configured to align the carrier member with the components to be coated.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

The following reference numerals are used throughout the description
SO radiation source
LA lithographic apparatus
B, B' EUV radiation beam
IL illumination system
MT support structure
MA patterning device
PS projection system
WT substrate table
W substrate
10 facetted field mirror device
11 facetted pupil mirror device
13, 14 mirrors
20 patterning device environment
22 reticle mini environment (RME)
24 clamp
26 fiducials
28 short stroke patterning device actuator
30 long stroke actuator
32 patterning device masking apparatus
33 masking blade
33a conductive bulk
33b, 33c, 33d dielectric surface layer of masking blade
34 radiation beam
36 motion/control module
38 radiation beam uniformity adjustment apparatus
40 illuminator top sleeve flow supply (ITS flow supply)
42 G-mirror (grazing incidence mirror)
44 patterning device exchange apparatus
46 pod
48 gas refreshing system
50 component
50a conductive bulk of component
50b dielectric surface layer of component
51 particle
51a conductive bulk of particle
51b dielectric surface layer of particle
54 energetic electrons
55 charge build-up on particle dielectric surface
56 charge build-up on component dielectric substrate
70a, 70b, 70c, 70d, 70e, 70f, 70g, 70h carrier member
72 carrier plate
74 precursor material
76 irradiated portion
78 fins
82 frame
84 carrier membrane
84a first carrier membrane
84b second carrier membrane
90 conductive coating

## Claims

1. A method for applying a conductive coating to a component of a lithographic apparatus, comprising:
providing a carrier member in the lithographic apparatus, wherein a precursor material is disposed on the carrier member,
heating the carrier member to form a vapor of the precursor material,
condensing the precursor vapor onto the component to form the conductive coating.

2. The method according to claim 1, wherein the heating is provided to the carrier member with a radiation beam, optionally, wherein the radiation beam is a beam of extreme ultraviolet radiation, ultraviolet radiation, visible radiation or infrared radiation.

3. The method according to any of the preceding claims, wherein the precursor material is disposed on a portion of the carrier member that faces the component to be coated.

4. The method according to any of the preceding claims, wherein the component and the carrier member are each disposed in a reticle mini environment area of the lithographic apparatus, optionally, wherein the component comprises one or more of a reticle masking blade, a gas supply system, a gas exhaust system and a beam uniformity adjustment apparatus.

5. The method according to any of the preceding claims, wherein the lithographic apparatus comprises a clamp configured to hold a reticle in normal use, wherein the carrier member is attached to the reticle or to the clamp, and/or the carrier member is supported by mechanical actuators, optionally, wherein the carrier member comprises a carrier plate which is attached to the clamp or to the reticle.

6. The method according to any of the preceding claims, wherein the carrier plate has a thermal conductivity of at least 50 Wm⁻¹K⁻¹, preferably more than 100 Wm⁻¹K⁻¹.

7. The method according to any one of claims 5 or 6, wherein the precursor vapor is guided by at least one fin integrated into the carrier plate, the at least one fin protruding from the carrier plate towards the component, optionally, wherein the at least one fin restricts propagation of the precursor vapor to areas other than a predetermined area of the component.

8. The method according to any one of claims 1 to 4, wherein the carrier member comprises a carrier membrane supported by a frame.

9. The method according to any of the preceding claims, wherein the precursor material comprises at least one metal oxide, optionally, wherein the at least one metal oxide is selected from one of molybdenum oxide, ruthenium oxide, iridium oxide, rhenium oxide, niobium oxide and tungsten oxide.

10. The method according to any of the preceding claims, wherein the precursor material is selectively applied to regions of the carrier member which face the component during the conductive coating application.

11. A method of maintaining a component of a lithographic apparatus, comprising:
monitoring level of particles added to a reticle during exposure, and
performing the method of any one of the preceding claims when the level of particles added to a reticle during exposure exceeds a predetermined threshold.

12. A carrier member for applying a conductive coating to components of a lithographic apparatus, the carrier member comprising a carrier plate or a carrier membrane having a melting point of more than 600 K and comprising a precursor material disposed thereon.

13. The carrier member according to claim 12, wherein the precursor material comprises at least one metal oxide.

14. The carrier member according to claim 13, wherein the at least one metal oxide is selected from one of molybdenum oxide, ruthenium oxide, iridium oxide, rhenium oxide, niobium oxide and tungsten oxide.

15. The carrier member according to any of claims 12 to 14, wherein the precursor material comprises one or more of: MoOs, RuO₄, IrO₃, ReO₄, NbO, WO₃.
